Europäisches Patentamt

European Patent Office

Office européen des brevets

(11) Veröffentlichungsnummer: **0 378 084**
**A2**

(12) **EUROPÄISCHE PATENTANMELDUNG**

(21) Anmeldenummer: **90100061.2**

(51) Int. Cl.⁵: **G01R 17/02**

(22) Anmeldetag: **03.01.90**

(30) Priorität: **07.01.89 DE 3900274**

(43) Veröffentlichungstag der Anmeldung:
**18.07.90 Patentblatt 90/29**

(84) Benannte Vertragsstaaten:
**CH DE GB LI**

(71) Anmelder: **BASF Aktiengesellschaft**
**Carl-Bosch-Strasse 38**
**D-6700 Ludwigshafen(DE)**

(72) Erfinder: **Zimmermann, Clifton, Dr.**
**Ludwig-Wilhelm-Strasse 2**
**D-7500 Karlsruhe 1(DE)**
Erfinder: **Kuerten, Heribert, Dr.**
**Oelbergstrasse 29**
**D-6730 Neustadt(DE)**
Erfinder: **Lewin, Helmut**
**Wormser Landstrasse 30**
**D-6712 Bobenheim-Roxheim(DE)**

(54) **Messschaltung zur Erfassung von Messsignalen.**

(57) Für Ultrapräzisionsmessungen ist ein Regelkreis, der aus einer Regelstrecke (S), einem Soll-Ist-Wert-Vergleicher (V) und einem Regler (R) besteht, in der Weise erweitert, daß zur Erfassung von Meßsignalen die die Regelgröße führende Verbindung (LWL) zwischen dem Reglerausgang und dem Regelstreckeneingang über einen Meßwertgeber (G) geführt ist. Zur Auswertung und Anzeige des Meßwertes ist der die Stellgröße (Y) führende Ausgang des Reglers zusätzlich mit einem Auswerteschaltung (A) verbunden.

FIG.1

EP 0 378 084 A2

## Meßschaltung zur Erfassung von Meßsignalen

Die Erfindung betrifft eine Meßschaltung zur Erfassung von Meßsignalen, die von einem geschlossenen Regelkreis mit einer Regelstrecke, einem Soll-Ist-Wertvergleicher und einem Regler ausgeht.

Für Präzisionsmessungen, beispielsweise von Oberflächen oder Schichtdicken oder bei Rotationskörpern, standen bisher Meßeinrichtungen zur Verfügung, die in ihrer Meßgenauigkeit und Präzision bei mechanischen Meßwerken durch die Mechanik und bei elektrischen Meßschaltungen durch Störsignale, insbesondere durch Rauschen und Driften begrenzt sind.

Es war daher die Aufgabe zu lösen, eine Meßschaltung zur Erfassung von Meßsignalen zu entwickeln, die für Ultrapäzisionsmessungen geeignet ist.

Die Aufgabe wurde ausgehend von einem Regelkreis der eingangs geschilderten Art gelöst, bei dem die die Regelgröße führende Verbindung zwischen dem Reglerausgang und dem Regelstreckeneingang über einen Meßwertgeber geführt ist und der die Stellgröße führende Ausgang des Reglers zusätzlich mit einer Auswerteschaltung verbunden ist.

In einer vorteilhaften Ausführungsform der Meßschaltung ist der die Regelgröße führende Reglerausgang über optoelektronische Wandler durch einen Lichtwellenleiter mit dem Regelstreckeneingang verbunden und der Lichtwellenleiter mittels einer optischen Weiche über einen optischen Sensor geführt.

Die erfindungsgemäße Meßschaltung ist anhand eines in der Zeichnung schematisch dargestellten Ausführungsbeispiels nachfolgend beschrieben.

Es zeigen ein Blockschaltbild der gesamten Meßschaltung

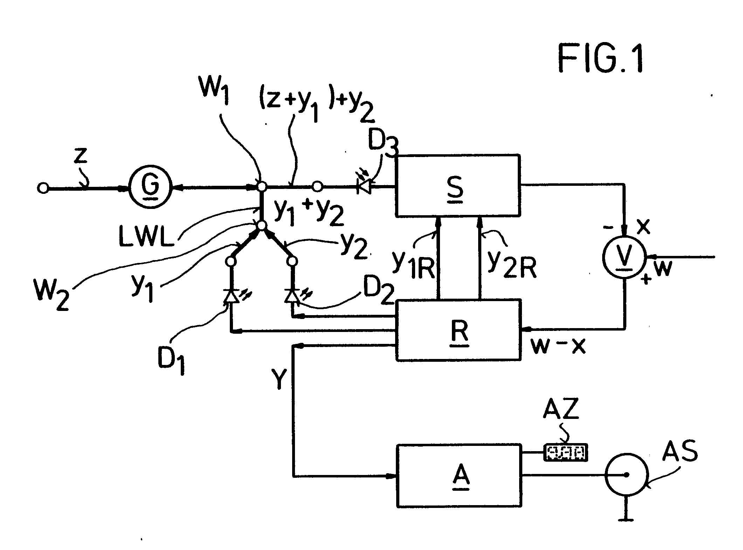

Figur 1 den schematischen Aufbau der einzelnen Blöcke

Figur 2 bis 4

Zentraler Teil der Meßschaltung ist, wie Figur 1 zeigt, ein geschlossener Regelkreis, der aus einer Regelstrecke S, einem Soll-Ist-Wertvergleicher V und einem Regler R besteht. Zur Erfassung von Meßsignalen ist die die Regelgröße führende Verbindung zwischen dem Reglerausgang und dem Regelstreckeneingang über einen Meßwertgeber G geführt, der die Regelgröße entsprechend der zu messenden Größe beeinflußt. Im vorliegenden Ausführungsbeispiel besteht diese Verbindung aus einem Lichtwellen leiter LWL, der mittels optoelektronischer Wandler $D_1$ bis $D_3$ an den Regelkreis angeschlossen ist. Der optoelektronische Regelkreis ist besonders für die Anwendung im Ex-Bereich vorteilhaft, kann je nach zu messender Größe aber auch durch eine direkte elektrische oder elektromagnetische Meßschleife geschlossen werden. Auf Grund der geringen Dämpfung des LWL kann der Sensor G in großer Entfernung (mehrere Kilometer) von der Meßschaltung zum Einsatz kommen. Der den Meßwert z aufnehmende Sensor G, beispielsweise eine Tastspitze, moduliert die Lichtimpulse $y_1$ im LWL. Dies geschieht z.B. durch Beeinflussung der Reflexion des am Ende des LWL austretenden Lichtes. Die Trennung der reflektierten modulierten Impulssignale $z + Y_1$ und der von der Laserdiode $D_1$ gesendeten Impulssignale $y_1$ wird durch eine optische Weiche $W_1$ vorgenommen, so daß eine Photodiode $D_3$ am Eingang der Strecke S nur die modulierten Signale empfängt. Wie nachstehend im einzelnen erläutert ist, erzeugt der Regler R eine der Modulation entsprechende Stellgröße Y, um die Modulation des Signals in der Regelstrecke durch entgegenwirkendes Nachführen des Sendesignals auszugleichen. Der Ausgleich erfolgt in diesem Falle mit einer Zeitverzögerung von maximal 10 $\mu$s, so daß annähernd ein Echtzeitverhalten angenommen werden kann. Dabei repräsentiert die Stellgröße den vom Sensor aufgenommenen Meßwert, die in einer Auswerteschaltung A zur Anzeige bzw. weiteren Meßwertverarbeitung aufbereitet wird. Die gesamte Schaltung des Regelkreises ist so aufgebaut, daß anstelle eines optoelektronischen Meßkreises jede andere Sende- und Empfangskonfiguration, beispielsweise mit piezoelektrischen oder elektromagnetischen Komponenten, ohne Schaltungsänderung einsetzbar ist.

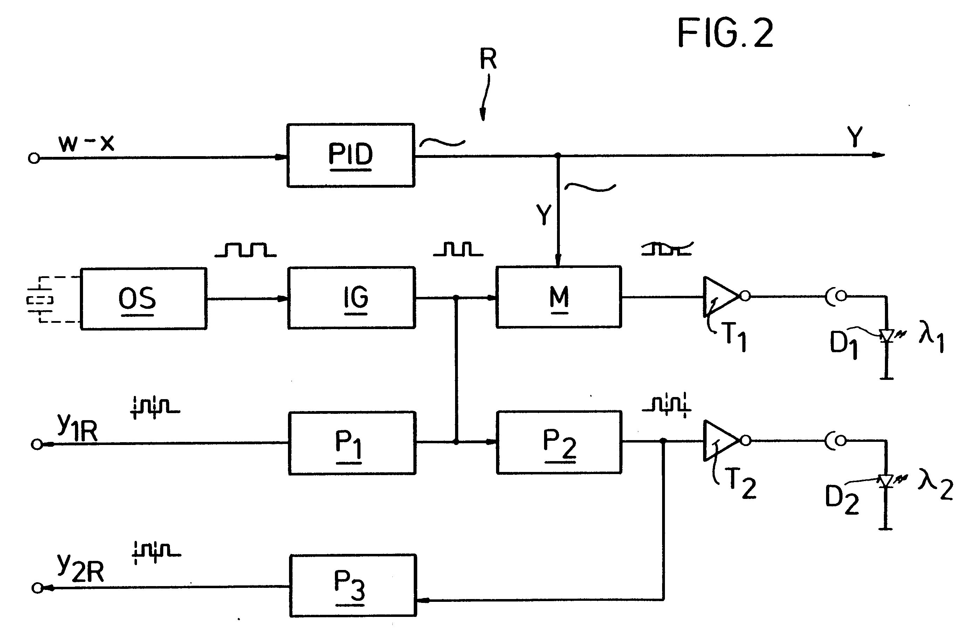

Für die Lichtemission $\lambda_1$ in den LWL wird die Laserdiode $D_1$ von Impulsen angesteuert, die in der Schaltungseinheit "Regler" R (Figur 2) erzeugt werden. Hierzu ist ein Oszillator OS vorgesehen, dessen symmetrische Rechteckspannung definierter, einstellbarer Frequenz in einem Impulsgenerator IG in kurze Rechteckimpulse einer von der Oszillatorfrequenz abhängigen Breite zwischen 100 $\mu$s und 100 ns umgesetzt wird. Auf den Impulsgenerator folgt ein Mischer M mit einer Mudulationstiefe von 14 Bit, in dem die Impulse entsprechend der Stellgröße Y eines PID-Reglers moduliert werden. Der Ausgang des Mischers ist über einen Treiberstärker $T_1$ mit der Laserdiode $D_1$ verbunden, die die in ihrer Höhe modulierten Impulse in Lichtimpulse $y_1$ umwandelt.

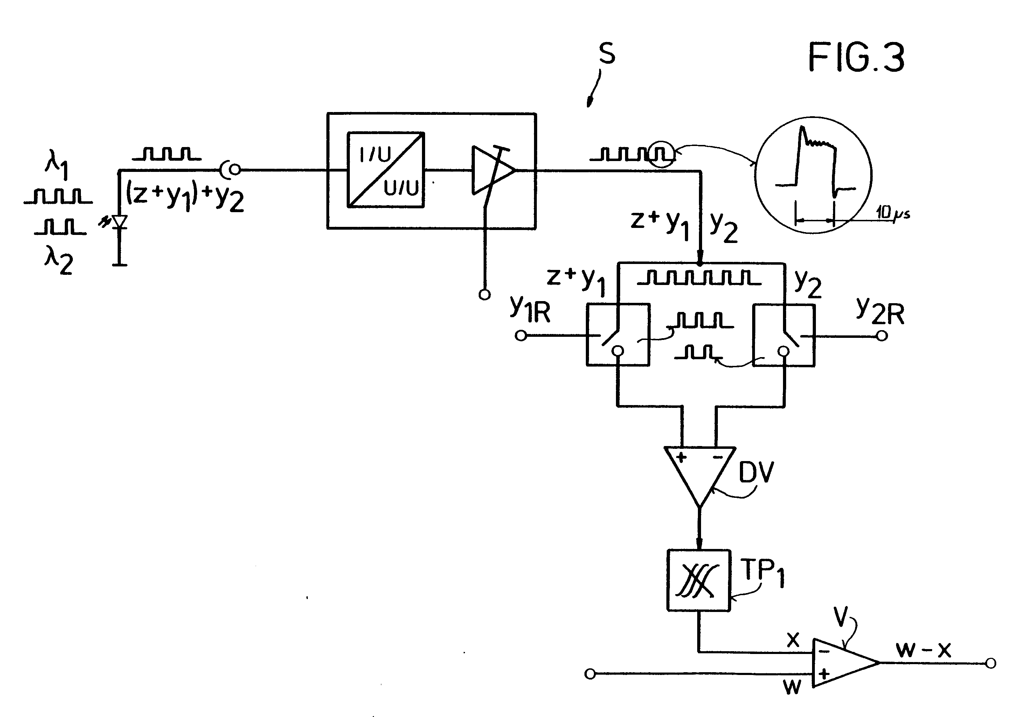

Wie vorstehend geschildert, durchlaufen die Lichtimpulse die Meßschleife und werden, vom Sensor G moduliert, in der Empfangsdiode $D_3$ in elektrische Impulse umgewandelt. Wegen des hohen Rauschanteils im Empfangssignal müssen die Impulse in der Regelstrecke S (Figur 3) aufbereitet werden. Hierfür ist nach einem Strom-/Spannungswandler I/U (Eingangsimpedanz etwa $10^{15}$ $\Omega$, Transimpedanz $\leq 10^8$ V/A bzw. Spannungsverstärkung $\leq 10^6$ V/V bei einer Bandbreite von 0 bis 3 MHz (-3 dB)) ein Auftast- und Halteglied $AH_1$ vorgesehen, in welchem die Impulse $y_1$ durch Referenzsignale $y_{1R}$ kohärent aufgetastet werden. Der Auftasteingang für die Referenzimpulse ist zur Kompensation von Laufzeitunterschieden über ein Verzögerungsglied $P_1$ mit dem Impulsgenerator IG verbunden.

Zur Kompensation von Instabilitäten des Regelkreises und der faseroptischen Strecke ist ein weiteres Auftast- und Halteglied $AH_2$ vorgesehen, an dessen Signaleingang Impulse $y_2$ wirksam sind, die von einer zweiten, über eine optische Weiche $W_2$ mit dem LWL verbundenen, Laserdiode $D_2$ erzeugt werden. Diese wird über ein Verzögerungsgleid $P_2$ und einen nachfolgenden Treiberverstärker $T_2$ ebenfalls vom Impulsgenerator IG angesteuert, wobei das Verzögerungsglied so bemessen ist, daß die Impulse $y_2$ um eine halbe Taktperiode verschoben zwischen den aufeinanderfolgenden Impulsen $y_1$ gesendet werden. Durch Wahl einer Laserdiode mit einer gegenüber der Laserdiode $D_1$ unterschiedlichen Wellenlänge $\lambda_2$ und ein am sensorseitigen Ende des LWL angebrachtes optisches Filter, welches für das Laserlicht $\lambda_1$ durchlässig ist, für $\lambda_2$ jedoch einen Reflektor darstellt, wird erreicht, daß ein Vergleichssignal $y_2$ zur Verfügung steht, das wie die Imulse $y_1$ Instabilitäten und Störungen des Regelkreises und der faseroptischen Strecke, wie Signaldrift, Rauschen, Temperatureinflüsse und Deformationen des LWL, aber kein Meßsignal enthält. Das kohärente Auftasten der Impulse $y_2$ erfolgt durch das Referenzsignal $y_{2R}$, welches über ein weiteres Verzögerungsglied $P_3$ vom Ansteuerkreis der Laserdiode $D_2$ abgeleitet wird.

Von den beiden zeitversetzten Impulsfolgen $y_1$ und $y_2$ ist an den beiden Auftast- und Haltegliedern $AH_1$ und $AH_2$ durch die Referenzsignale $y_{1R}$ und $y_{2R}$ jeweils immer nur eine wirksam. Durch die Auftastung erscheinen am Ausgang der beiden Auftast- und Halteglieder um $\omega_0 = 2\,\pi/T_0$ frequenztransformierte Signale, deren Rauschanteile bis auf höhere, phasengleiche Harmonische $\omega_i$ weitgehend unterdrückt sind. Der nachfolgende Differenzverstärker DV bewirkt die Kompensation des in beiden Ausgangssignalen gleichermaßen enthaltenen störenden DG-Anteils, so daß am Ausgang des auf den Verstärker folgenden Tiefpasses $TP_1$ der tatsächliche Ist-Wert x des Regelkreises erscheint.

Ein als Soll-Ist-Wertvergleicher V dienender Differenzverstärker bildet aus dem Ist-Wert x und einem Soll-Wert w das Fehlersignal w-x, das auf den PID-Regler geführt ist. Die PID-Regler erzeugt daraus die Stellgröße Y, mit der im Mischer M die Impulse des Impulsgenerators IG so moduliert werden, daß die Differenz w-x am Ausgang des Vergleiches gleich Null wird.

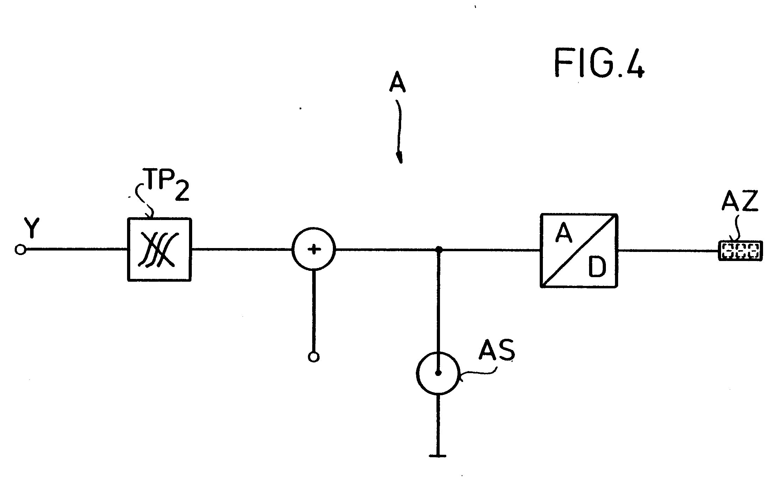

Die Größe Y stellt aber auch das eigentliche Meßsignal dar, das, wie bereits erwähnt, zur Anzeige des Wertes der zu messenden Größe bzw. weiteren Meßwertverarbeitung einer Auswerteschaltung A (Figur 4) zugeführt wird. Diese Schaltungseinheit besteht aus einem Tiefpaß $TP_2$, an dessen Ausgang ein geglättetes Signal erscheint. Der Ausgang ist mit einer Anzeigeeinheit AZ, beispielsweise einer Digitalanzeige mit einem vorgeschalteten Analog-/Digital-Wandler A/D, sowie mit einem Analogsignalausgang AS verbunden. Erforderlichenfalls weist die Verbindung zwischen dem Tiefpaßausgang und der Anzeigeeinheit eine Offset-Kompensation auf, um das Meßsignal an beliebiger Stelle auf Null setzen zu können.

## Ansprüche

1. Meßschaltung zur Erfassung von Meßsignalen, bestehend aus einem geschlossenen Regelkreis mit einer Regelstrecke (S), einem Soll-Ist-Wert-Vergleicher (V) und einem Regler (R), dadurch gekennzeichnet, daß die die Regelgröße führende Verbindung zwischen dem Reglerausgang und dem Regelstreckeneingang über einen Meßwertgeber (G) geführt ist und der die Stellgröße (Y) führende Ausgang des Regelers (R) zusätzlich mit einer Auswerteschaltung (A) verbunden ist.

2. Meßschaltung nach Anspruch 1, dadurch gekennzeichnet, daß der die Regelgröße führende Reglerausgang über optoelektronische Wandler ($D_1$ - $D_3$) durch einen Lichtwellenleiter (LWL) mit dem Regelstreckeneingang verbunden ist und der Lichtwellenleiter mittels einer optischen Weiche ($W_1$) über einen optischen Sensor (G) geführt ist.

3. Meßschaltung nach Anspruch 1 und 2, dadurch gekennzeichnet, daß zur Detektion der Meßsignale eine Referenzsignalquelle ($y_{1R}$) vorgesehen ist, mit deren Signale die Meßsignale in der Regelstrecke (R) mit Hilfe eines Auftast- und Haltegliedes ($AH_1$) kohärent aufgetastet werden.

4. Meßschaltung nach Anspruch 1 bis 3, dadurch gekennzeichnet, daß zur Kompensation von Instabilitäten des Regelkreises und der faseroptischen Strecke eine zweite, über ein Verzögerungsglied ($P_2$) von der Signalquelle (IG) des Reglers (R) ansteuerbare, optoelektronische Signalquelle ($D_2$) vorgesehen ist, deren Signale zwischen den aufeinanderfolgenden Meßsignalimpulsen mit einer von diesen abweichenden Wellenlänge, die von einem unmittelbar vor dem optischen Sensor (G) angeordneten Filter reflektiert wird, in den Lichtwellenleiter (LWL) eingekoppelt und nach einem optischen Wandler ($D_3$) in einem zweiten Auftast- und Halte-

glied (AH$_2$) mit Hilfe der Signale einer zweiten Referenzsignalquelle (y$_{2R}$) aufgetastet werden, und die Ausgänge der beiden Auftast- und Halteglieder (AH$_1$; AH$_2$) auf einen Differenzverstärker (DV) geschaltet sind, dessen Ausgang auf einen Tiefpaß (TP$_1$) geführt ist.

FIG.1

EP 0 378 084 A2

FIG.2

FIG.3

EP 0 378 084 A2

FIG.4

EP 0 378 084 A2